# EUROPÄISCHE PATENTSCHRIFT

(11) **EP 2 754 793 B1**
(45) Veröffentlichungstag und Bekanntmachung des Hinweises auf die Patenterteilung: **11.09.2019**
(21) Anmeldenummer: 14150753.3
(22) Anmeldetag: 10.01.2014
(51) Int. Cl.: E05B 47/02, E05B 47/00, E05B 17/22, E05C 19/16

(54) **Zugangbestimmende Vorrichtung in einem Gebäude**
Access control device in a building
Dispositif de détermination d'accès dans un bâtiment

(30) Priorität: 11.01.2013 DE 102013000282; 26.04.2013 DE 102013007287
(43) Veröffentlichungstag der Anmeldung: 16.07.2014
(73) Patentinhaber: ASSA ABLOY Sicherheitstechnik GmbH, 72458 Albstadt (DE)
(72) Erfinder: Ammann, Peter, 72406 Bisingen (DE)
(74) Vertreter: Louis Pöhlau Lohrentz

(56) Entgegenhaltungen:
- EP-A1- 2 055 352
- DE-A1-102010 036 772
- US-A- 5 633 626
- US-B1- 6 271 751

## Beschreibung

Die Erfindung betrifft eine zugangbestimmende Vorrichtung in einem Gebäude nach den Merkmalen des Oberbegriffs des Anspruchs 1.

Ein solche ist in US 6 271 751 B1 gezeigt. Hierbei wird eine Tür durch einen Haftmagneten in einer Schließposition gehalten. Die Stromzufuhr zu diesem Haftmagneten wird kurzzeitig (kleiner 15 ms) abgeschaltet und die resultierende Gegenspannung gemessen um auf den Schließzustand der Tür zu schließen.

In DE 10 2010 036 772 A1 wird zur Überwachung einer Verschlussstellung eines Stellteils eines Staubsaugers mittels eines Elektromagneten dieser mit einer Spannung beaufschlagt wobei der Zeitraum bis zum Erreichen des dem vorgegebenen Spannungswert entsprechenden Spulen-Stromwertes des Elektromagneten bestimmt wird.

Beispielsweise kann es sich bei der zugangbestimmenden Vorrichtung um eine Rettungswegtürvorrichtung handeln; eine Rettungswegtüre ermöglicht den Zugang zu einem Rettungsweg aus dem Gebäude heraus. Die Rettungswegtüre ist in einem Grundzustand mittels einer elektrischen Verriegelungseinrichtung geschlossen und wird erst in einem Ausnahmezustand (Notfall) geöffnet. Durch das Öffnen der Verriegelungseinrichtung wird das Öffnen der Türe, etwa von Hand durch eine menschliche Person, ermöglicht. Die elektrische Verriegelungseinrichtung kann als elektrischer Türöffner und/oder als elektrischer Haftmagnet ausgebildet sein. Eine weitere Anwendung besteht im Bereich von Brandschutztüren, z. B. als elektrische Feststellanlage für ein- oder zweiflügelige Türen mit Türschließern, vorzugsweise Gleitarmtürschließern mit der Feststelleinrichtung in der Gleitschiene; bei einer Brandschutztürvorrichtung wird die Brandschutztüre dauerhaft offen gehalten, etwa auf einem Gang, um Personen zu ermöglichen, von einer Seite eines Türrahmens mit der Brandschutztüre zu der anderen Seite zu gelangen und umgekehrt. Im Grundzustand wird somit ein Schließen der Türe verhindert, und erst in einem Ausnahmezustand (Notfall) wird ein Schließen der Türe ermöglicht, wobei das Schließen dann zumeist selbsttätig erfolgt, etwa unter der Wirkung einer Feder, z. B. eines Türschließers mit Schließfeder und hydraulischer Dämpfungseinrichtung, gegebenenfalls auch unter der Wirkung eines Elektromotors, z. B. eines elektromechanischen oder elektrohydraulischen Türantriebs. Die Erfindung betrifft auch ein Prüfverfahren in einer zugangbestimmenden Vorrichtung.

Die zugangbestimmende Vorrichtung kann in einem Gebäude ausgebildet sein, und zumindest eine Türe und einen der Türe zugeordneten Elektromagneten aufweisen, welche über zumindest einen Schalter mit einer Spannungsquelle gekoppelt ist. Der Schalter ist in einem Grundzustand der zugangbestimmenden Vorrichtung geschlossen, sodass ein Elektromagnet bestromt ist und dieser bewirkt, dass ein mit einem so erzeugten Magnetfeld des Elektromagneten beaufschlagtes, ebenfalls der Türe zugeordnetes Feststellelement ein Öffnen der Türe oder ein Schließen der Türe verhindert, wobei erst in einem Ausnahmezustand durch dauerhaftes Öffnen des zumindest einen Schalters ein Wegfall des Magnetfeldes des Elektromagneten bewirkt wird und ein Öffnen der Türe oder ein Schließen der Türe ermöglicht wird.

Bei der zugangbestimmenden Vorrichtung ist somit das Ruhestromprinzip verwirklicht: Im Ruhe- bzw. Grundzustand ist der Elektromagnet bestromt. Dies hat den Grund, dass bei einer sicherheitsrelevanten zugangbestimmenden Vorrichtung gewährleistet sein muss, dass bei Ausfall des elektrischen Stroms die Sicherheitsmaßnahme getroffen wird. Bei einer Rettungswegtüre muss sich die Türe bei Ausfall des elektrischen Stroms öffnen lassen. Bei einer Brandschutztüre muss diese sich schließen, wenn der Strom wegfällt.

Der Schalter, welcher mit der Spannungsquelle gekoppelt ist, dient dazu, nun mit Absicht den Grundzustand zu verlassen. Beispielsweise kann der Schalter über einen Notaustaster betätigbar (nämlich zu öffnen) sein, der an einer Rettungswegtüre angeordnet ist.

In sicherheitsrelevanten Gebäudeeinrichtungen nach Art der zugangbestimmenden Vorrichtung der oben genannten Gattung ist es nun wichtig, dass der Schalter regelmäßig auf Funktionsfähigkeit geprüft wird. Herkömmlicherweise in solchen zugangbestimmenden Vorrichtungen vorgesehene elektromechanische Relais lassen sich jedoch nur überprüfen, wenn das Verlassen des Grundzustands in Kauf genommen wird: Wird das Relais im Rahmen einer Funktionsprüfung geöffnet und wieder geschlossen, wird in der Zwischenzeit der Elektromagnet entregt, sein Magnetfeld fällt weg, und es wird zwischenzeitlich ein Öffnen der Türe (Rettungswegtüre) oder ein Schließen der Türe (Brandschutztüre) ermöglicht. Dies ist unerwünscht. Man behilft sich somit damit, in einem Gebäude eigens eine Prüfung der zugangbestimmenden Vorrichtung vorzunehmen und hierbei Maßnahmen zu treffen, dass der Alltag nicht beeinträchtigt wird. Beispielsweise erfolgt die Prüfung der Relais in einem Kaufhaus mit Rettungswegtüren nachts, wenn sich (außer dem Prüfpersonal) keine Personen in dem Gebäude befinden. Bei Prüfung der Relais in einer Brandschutztürvorrichtung schließen sich die Brandschutztüren und müssen manuell wieder geöffnet werden.

Naturgemäß sind solche Prüfungen der Gebäudeverwaltung sehr unlieb, auch wegen der damit verbundenen Kosten.

Es ist eine Aufgabe der vorliegenden Erfindung, bei einer zugangbestimmenden Vorrichtung nach der oben beschriebenen Gattung dafür zu sorgen, dass in erhöhtem Maße für eine Sicherheit gesorgt ist, indem Funktionsprüfungen leichter und damit häufiger erfolgen können.

Die Aufgabe wird durch eine zugangbestimmende Vorrichtung nach dem Oberbegriff des Patentanspruchs 1 gelöst, die dadurch gekennzeichnet ist, dass der zumindest eine Schalter ein Halbleiterschalter oder sonstiger in einem Millisekundentakt schaltbarer Schalter ist, wobei der Schalter über eine Steuerleitung angesteuert wird. Ferner ist eine Prüfeinrichtung vorgesehen, welche ausgelegt ist, zumindest ein Signal zum Bewirken des Öffnens des Schalters ausgehend von dem Grundzustand für eine derart kurze Dauer (insbesondere über die Steuerleitung, wenn vorhanden) auszusenden, dass ein Öffnen bzw. Schließen der Türe noch nicht ermöglicht wird. Die Prüfeinrichtung ist ferner ausgelegt, anhand einer Erfassungseinrichtung zu prüfen, ob der Schalter aufgrund des zumindest einen Signals zum Öffnen tatsächlich geöffnet wird. Ferner ist der Elektromagnet erfindungsgemäß über zumindest zwei Halbleiterschalter (oder zwei sonstige in einem Millisekundentakt schaltbare Schalter) mit zugehöriger Steuerleitung mit der Spannungsquelle redundant derart gekoppelt, dass wenn einer der Halbleiterschalter geöffnet wird, der Elektromagnet entregt und der Ausnahmezustand eingenommen wird.

Die Erfindung beruht auf der Erkenntnis, dass Halbleiterschalter, die im Millisekundentakt schaltbar sind (oder sonstige Schalter mit diesen Eigenschaften) geöffnet und geschlossen werden können, ohne dass eine Reaktion im Bereich des Feststellelements in der zugangbestimmenden Vorrichtung mit diesen Halbleiterschaltern erfolgt. Insbesondere kann man den Halbleiterschalter so schnell schalten, dass der Elektromagnet so gut wie noch nicht entregt ist (wegen der wesentlich größeren Relaxationszeit) und/oder auch die Mechanik (des Feststellelements) noch nicht entsprechend schnell reagieren kann.

Die Erfindung führt somit das Konzept ein, bei einer zugangbestimmenden Vorrichtung den Schalter, durch dessen Öffnen der Ruhestromzustand verlassen wird und der Ausnahmezustand hergestellt wird, zu überprüfen, ohne dass es Beeinträchtigungen im Alltagsbetrieb in dem Gebäude gibt; eine Rettungswegtüre lässt sich daher nicht kurzzeitig öffnen, wenn der Schalter geprüft wird, sondern sie bleibt hiervon nicht beeinflusst verriegelt; eine Brandschutztüre wird nicht freigegeben, sodass sie sich schließen kann.

Die Aufgabe wird auch durch ein Verfahren zum Prüfen eines Halbleiterschalters in einer zugangbestimmenden Vorrichtung eines Gebäudes mit zumindest einer Türe gelöst, der ein Elektromagnet zugeordnet ist, welcher über den zu prüfenden Halbleiterschalter mit einer Spannungsquelle gekoppelt ist, wobei der Halbleiterschalter in einem Grundzustand der zugangbestimmenden Vorrichtung geschlossen ist, sodass der Elektromagnet bestromt ist und bewirkt, dass ein mit einem so erzeugten Magnetfeld des Elektromagneten beaufschlagtes, ebenfalls der Türe zugeordnetes Feststellelement ein ordnungsgemäßes Öffnen der Türe oder ein ordnungsgemäßes Schließen der Türe verhindert, wobei in einem Ausnahmezustand durch dauerhaftes Öffnen des zumindest einen Schalters ein Wegfall des Magnetfeldes des Elektromagneten bewirkt wird und ein Öffnen der Türe oder ein Schließen der Türe ermöglicht wird, wobei der Halbleiterschalter für eine derart kurze Zeitdauer geöffnet wird, insbesondere für weniger als 6 ms, dass ein Öffnen bzw. Schließen der Türe noch nicht ermöglicht wird. Das Verfahren ist dadurch gekennzeichnet, dass der Elektromagnet über zumindest zwei Halbleiterschalter (oder zwei sonstige in einem Millisekundentakt schaltbare Schalter) mit zugehöriger Steuerleitung mit der Spannungsquelle redundant derart gekoppelt ist, dass wenn einer der Halbleiterschalter geöffnet wird, der Elektromagnet entregt und der Ausnahmezustand eingenommen wird, und dass das Öffnen eines Halbleiterschalters mittels einer Erfassungseinrichtung detektiert wird.

Die zu der Vorrichtung genannten Vorteile gelten entsprechend für das erfindungsgemäße Verfahren.

Das Verfahren beinhaltet bevorzugt, dass das Öffnen des Halbleiterschalters in einem Grundbetrieb mindestens täglich, bevorzugt mindestens stündlich, ganz bevorzugt mindestens mehrmals stündlich (insbesondere in regelmäßigen Abständen wie etwa von 15 Minuten) wiederholt wird.

Ein Verfahren bezieht sich auf eine erfindungsgemäße zugangbestimmende Vorrichtung und die Prüfung eines Schalters in dieser.

Die Erfindung ermöglicht somit ein beständiges Überprüfen des Halbleiterschalters auf seine Funktionsfähigkeit und sorgt daher in besonderem Maße für eine Sicherheit hinsichtlich der zugangbestimmenden Vorrichtung.

Bei einer bevorzugten Ausführungsform der zugangbestimmenden Vorrichtung ist der Elektromagnet über zumindest zwei Halbleiterschalter mit zugehöriger Steuerleitung mit der Spannungsquelle gekoppelt. Die Prüfeinrichtung ist ausgelegt, die zumindest zwei Halbleiterschalter in wechselnder Konfiguration anzusteuern. Durch das Vorsehen gleich zweier Halbleiterschalter (es wären auch zwei sonstige in einem Millisekundentakt schaltbare Schalter möglich) ist für Redundanz gesorgt, denn wenn einer der Schalter geöffnet wird, wird der Elektromagnet entregt, und der Ausnahmezustand wird eingenommen. Es besteht somit zumindest eine Einfehlersicherheit, d. h. einer der Schalter kann ausfallen, und es ist dennoch für eine Sicherheit gesorgt. Naturgemäß sind auch mehr als zwei Schalter einsetzbar. Beispielsweise ist bei Vorsehen von gleich drei Halbleiterschaltern eine sogenannte Zweifehlersicherheit gegeben.

Die zumindest zwei Halbleiterschalter können parallel zueinander vorgesehen sein, wenn nämlich die Spannungsquelle zwei Quell-Spannungsabgriffe hat, die im Grundzustand jeweils mit einem Verbraucher-Spannungsabgriff des Elektromagneten gekoppelt sind, kann zwischen jeweils einem Quell-Spannungsabgriff und jeweils einem Verbraucher-Spannungsabgriff zumindest ein (Halbleiter-)Schalter angeordnet sein. Dieser hat beispielsweise den Vorteil, dass bei Gegebensein von Störpulsen über eine Leitung zumindest ein Halbleiterschalter in der anderen Leitung (zwischen Quell-Spannungsabgriff und Verbraucher-Spannungsabgriff) unbeeinträchtigt bleibt.

Alternativ oder als ergänzende Maßnahme kann zwischen einem der Quell-Spannungsabgriffe und einem der Verbraucher-Spannungsabgriffe eine Reihenschaltung aus zwei (Halbleiter-)Schaltern bereitgestellt sein. Es kann sich beispielsweise empfehlen, die Halbleiterschalter hinsichtlich der nicht geerdeten Seite der Spannungsquelle in Reihe zu schalten.

Unter Einsatz zumindest eines kapazitiven Elements, welches die beiden Verbraucher-Spannungsabgriffe koppelt, kann in verbessertem Maße eine Abpufferung bewirkt werden: Beim Öffnen jeweils eines Schalters wird der Elektromagnet verzögert entregt, wenn sich zugleich das kapazitive Element entladen kann. Beim Wiedereinschalten des einen Schalters wird das kapazitive Element sodann wieder geladen. Ein zusätzliches Element wie etwa eine zusätzliche bidirektionale Diode oder ein Varistor kann dazu dienen, die Einkopplung von Störsignalen zu den empfindlichen Halbleiterschaltern zu unterbinden.

Bei einer bevorzugten Ausführungsform der Erfindung umfasst die Erfassungseinrichtung zu jedem Halbleiterschalter ein Halbleiterbauelement, wobei dieses über eine Ausgangsleitung zumindest ein Spannungssignal ausgibt. Es ist vorteilhaft, wenn die Erfassungseinrichtung ihrerseits Halbleiterbauelemente umfasst, weil diese entsprechend schnell auf das Öffnen und Schließen des Halbleiterschalters in den genannten kurzen Zeiten reagieren können.

Im Zusammenhang mit zwei Halbleiterschaltern und in der Erfassungseinrichtung zwei zugehörigen Halbleiterbauelementen ist bevorzugt vorgesehen, dass eine Steuereinrichtung der zugangbestimmenden Vorrichtung (z. B. ein Mikroprozessor oder ein Mikrocontroller) ausgelegt ist, Signale über die Steuerleitungen an die Halbleiterschalter zur Ansteuerung in wechselnder Konfiguration auszusenden und entsprechende (Ausgangs-)Spannungssignale von den Halbleiterbauelementen der Erfassungseinrichtung zu empfangen. Eine derartige Steuereinrichtung ist insbesondere in der Lage, die schnelle Taktung des Öffnens der Halbleiterschaltung und des entsprechenden Schließens vorzunehmen. Die Steuereinrichtung kann quasi im Dauerbetrieb arbeiten, um ständig und wiederholt alle Halbleiterschalter auf ihre Funktionsfähigkeit zu überprüfen.

Bei einer Variante in dieser Ausführungsform ist die Steuereinrichtung ausgelegt, die Halbleiterschalter mit unterschiedlichen Signalfolgen zu beaufschlagen, wobei sich die Signalfolgen von Halbleiterschalter zu Halbleiterschalter vorzugsweise durch ihre Frequenz voneinander unterscheiden. Die Spannungssignale, welche von den Halbleiterbauelementen der Erfassungseinrichtung ausgegeben sind, weisen sodann in derselben Signalfolge also insbesondere dieselbe Frequenz wie die entsprechend der Beaufschlagung des zugehörigen Halbleiterschalters auf, sodass die Halbleiterschalter besonders effizient untersucht werden können.

Das für eine effiziente Überprüfung der Halbleiterschalter zugrunde liegende Prinzip besteht darin, dass eine Steuerleitung galvanisch von dem Elektromagneten und/oder der Spannungsquelle entkoppelt ist. Auf diese Weise kann sich die Ansteuerung nicht in irgendeiner Form auf das Magnetfeld des Elektromagneten und damit das Feststellelement auswirken, und die Ansteuerung kann auch nicht die Spannungsquelle beeinträchtigen. Bei der Ausführungsform mit Halbleiterbauelementen in der Erfassungseinrichtung kann dann ferner entsprechend vorgesehen sein, dass die Ausgangsleitungen dieser Halbleiterbauelemente galvanisch von dem Elektromagneten und/oder der Spannungsquelle entkoppelt sind. Somit können diese Halbleiterbauelemente ebenfalls zwischen Quell-Spannungsabgriffe und Verbraucher-Spannungsabgriffe eingebaut werden, ohne dass die Erfassung des Schaltzustands des Schalters den Elektromagneten oder die Spannungsquelle in irgendeiner Form beeinflusst oder beeinträchtigt.

Bei einer bevorzugten Ausführungsform wird die Tatsache des Öffnens und Schließens der Halbleiterschalter dazu genutzt, eine Information zu übermitteln; der oder die Schalter werden somit gemäß einem Code angesteuert. Beispielsweise kann man dies nutzen, um auch eine Steuereinrichtung, die die Schalter ansteuert, auf Funktionsfähigkeit zu überprüfen. Auch Abfragen der Steuereinrichtung nach ihren Eigenschaften (Identität und entsprechende Codes) können auf diese Weise beantwortet werden.

Beispielsweise kann an der zugangbestimmenden Vorrichtung (oder woanders) ein Betätigungselement vorgesehen sein, durch das ein Aktivwerden der Prüfeinrichtung bewirkt wird, damit die Schalter geöffnet werden, insbesondere eben gemäß dem Code. Diese Maßnahmen sind auch insbesondere dann vorteilhaft, wenn einzelne Komponenten der zugangbestimmenden Vorrichtung oder mehrerer zugangbestimmender Vorrichtungen in ein und demselben Gebäude mit einem Datenbus gekoppelt sind, über den nach einem Busprotokoll Informationen ausgetauscht werden.

Neben dem Bereitstellen eines Codes kann die Prüfeinrichtung auch ausgelegt sein, Zufallssignale auszugeben (indem sie einen Zufallsgenerator umfasst), oder sie kann ausgelegt sein, ein pulsweitenmoduliertes Signal abzugeben.

Diese Zufallssignale können insbesondere dazu dienen, den Zeitpunkt des Aussendens des Signals zum Bewirken des Öffnens des Schalters festzulegen. Dadurch ist in erhöhtem Maße dafür gesorgt, dass unbefugte Personen nicht bei der Prüfung eingreifen; sie können nämlich den Zeitpunkt der Prüfung gar nicht vorhersagen.

Die Pulsweitenmodulation kann insbesondere beinhalten, dass die Dauer periodisch abgegebener Pulse und damit auch der Pulspausen zwischen diesen Pulsen in Abhängigkeit von einer gewünschten Leistung eingestellt wird: Je höher die Dauer der Pulse pro Periode ist, desto größer ist die aufzubringende Leistung. Die Prüfeinrichtung kann insbesondere mithilfe des pulsweitenmodulierten Signals auf Verriegelungseinrichtungen einwirken, und sobald diese sicher verriegelt sind, die Pulsdauer und damit die eingetragene Leistung verringern.

Bei der bevorzugten Ausführungsform währt die kurze Dauer, über die der zumindest eine Halbleiterschalter oder sonstige Schalter geöffnet wird, weniger als 6 ms, und vorzugsweise zwischen 0,5 und 2 ms. Es hat sich gezeigt, dass bei einer Taktung des Halbleiterschalters von weniger als 6 ms nicht nur verhindert wird, dass das Feststellelement mechanisch reagiert, sondern bei üblichen Einrichtungen in der zugangbestimmenden Vorrichtung treten dann auch keine hörbaren Effekte auf, also etwa kein Klacken in oder an der Türe.

Wie schon eingangs ausgeführt, kann die Türe eine Rettungswegtüre sein. In diesem Fall kann das Feststellelement entweder dazu dienen, einen Türflügel an einer Türzarge der Rettungswegtüre zu halten, oder es kann Teil eines elektrischen Türöffners an der Rettungswegtüre sein, oder schließlich kann es eine Druckstange an der Rettungswegtüre verriegeln. Also kann eine elektrische Verriegelungseinrichtung als elektrischer Türöffner oder Haftungsmagnet ausgebildet sein.

Bei einer anderen Ausführungsform ist die Türe eine Brandschutztüre und das Feststellelement dient dazu, diese Türe in einem geöffneten Zustand zu halten. Zur Bereitstellung der Feststellung in Offenlage der Türe kann ein Türschließer mit elektrischer Feststellung in einer Gleitschiene vorgesehen sein.

Nachfolgend werden bevorzugte Ausführungsformen der Erfindung unter Bezug auf die Zeichnung näher beschrieben in der:
- Fig. 1: die Komponenten einer Rettungswegtürvorrichtung als Beispiel einer erfindungsgemäßen zugangbestimmenden Vorrichtung in einem Gebäude veranschaulicht,
- Fig. 2: eine erste Schaltung bei einer ersten Ausführungsform der zugangbestimmenden Vorrichtung veranschaulicht,
- Fig. 3: eine zweite Schaltung bei einer zweiten Ausführungsform der zugangbestimmenden Vorrichtung veranschaulicht.

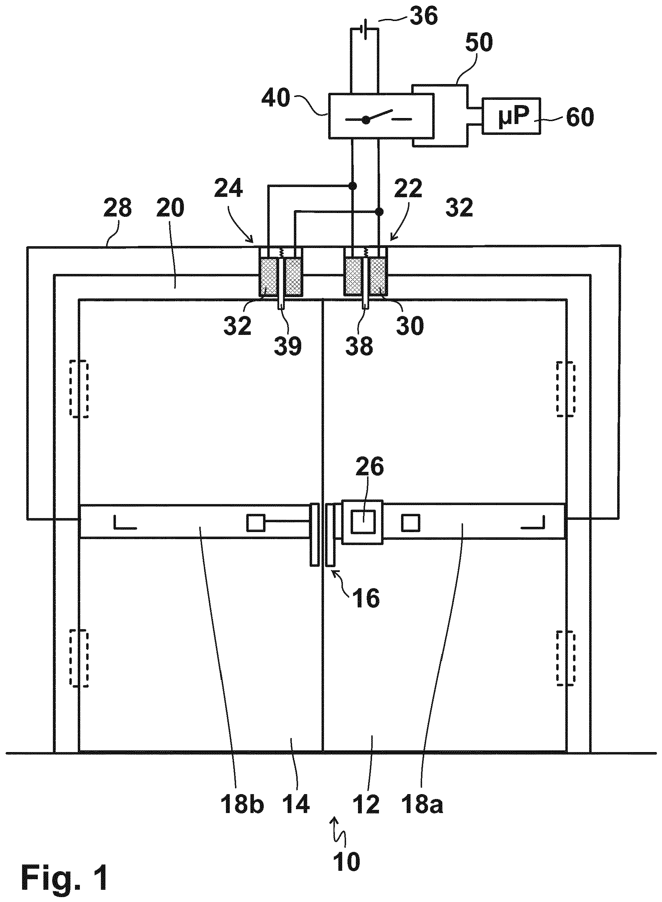

Eine in Fig. 1. gezeigte und im Ganzen mit 10 bezeichnete Rettungswegtüre, auch als Paniktüre bezeichenbar, umfasst einen aktiven Flügel 12 und einen passiven Flügel 14. Der aktive Flügel 12 kann unabhängig von dem passiven Flügel 14 geöffnet werden. Der passive Flügel 14 kann nur dann geöffnet werden, wenn auch der aktive Flügel 12 geöffnet ist. Die Erfindung ist auch bei einer einflügeligen Tür umsetzbar. In diesem Falle entfällt einfach der passive Flügel 14, d. h. die einflügelige Tür hat z. B. alle Eigenschaften des aktiven Flügels 12.

Die Türe weist ein Schloss 16 auf, welches eine in der Fig. 1 nicht zu sehende Falle und/oder einen Riegel aufweist, mittels derer bzw. dessen der aktive Flügel 12 an dem passiven Flügel 14 verriegelt ist. Der passive Flügel 14 umfasst eine sogenannte Standflügelverriegelung, welche den passiven Flügel zu einer Türzarge 20 verriegelt. Das Schloss kann durch Betätigen einer Druckstange geöffnet werden. Vorliegend erstrecken sich Druckstangenteile 18a und 18b über den aktiven Flügel 12 und den passiven Flügel 14. Die Erfindung ist jedoch auch dann realisierbar, wenn ein Schloss durch Betätigen eines Drückers oder einer Griffstange zu öffnen ist. Außerdem können auch mehrere Schlösser zugleich vorgesehen sein, die von demselben Betätigungselement oder mehreren Betätigungselementen unabhängig voneinander geöffnet werden können.

Vorliegend wäre ohne weitere Maßnahme die Türe 10 jederzeit durch Hineindrücken eines der Druckstangenteile 18a und 18b in Richtung zum Blatt des jeweiligen Türflügels 12 bzw. 14 hin zu öffnen. Um zu vermeiden, dass Personen missbräuchlich ein Gebäude verlassen oder anderen Personen den Zugang zu einem Gebäude ermöglichen, ist eine Rettungswegtüre üblicherweise verriegelt. Beispielsweise ist die Türe 10 dadurch verriegelt, dass jeder der beiden Türflügel 12 und 14 an einem oberen Bereich an der Türzarge 20 verriegelt ist. Das Verriegeln kann insbesondere mithilfe von Verriegelungsstangen erfolgen. Der aktive Türflügel 12 weist hierzu eine Verriegelungseinrichtung 22 auf, der passive Türflügel 14 eine Verriegelungseinrichtung 24. Die beiden Verriegelungseinrichtungen 22 und 24 umfassen jeweils einen Elektromagneten 30 bzw. 32, denen jeweils ein Feststellelement 38 bzw. 39 zugeordnet ist. Es wird das Ruhestromprinzip eingesetzt: Solange der Elektromagnet bestromt ist, ist die Türe 10 durch die Feststellelemente 38 bzw. 39 verriegelt.

Genauso kann auch eine Verriegelungseinrichtung mit einem Elektromagneten in oder an dem Betätigungselement vorgesehen sein, mit dem das Schloss geöffnet wird, etwa an einem der Druckstangenteile 18a und 18b. Die Erfindung kann sich auch auf diesen Fall beziehen. Schließlich kann in einem elektrischen Türöffner, der dem Schloss 16 zugeordnet ist, ebenfalls ein Elektromagnet vorgesehen sein. Die nachfolgend in Bezug auf die beiden Elektromagneten 30 und 32 der Verriegelungseinrichtungen 22 und 24 beschriebene Erfindung ist auf diese Fälle sämtlich übertragbar.

Die beiden Elektromagneten 30 und 32 der Verriegelungseinrichtungen 22 und 24 sind mit einer Spannungsquelle 36 gekoppelt, und zwar über eine Schalteinrichtung 40. Die Schalteinrichtung 40 wird im Beispielsfall galvanisch von der Spannungsquelle 36 und damit den Elektromagneten 30 und 32 getrennt, über eine Steuerleitung 50 von einem Mikroprozessor 60 angesteuert.

Gemäß dem Ruhestromprinzip ist in einem Grundzustand die Spannungsquelle 36 mit den beiden Elektromagneten 30 und 32 gekoppelt, so dass diese bestromt sind und die Türe 10 wie oben beschrieben verriegelt ist. Durch Öffnen eines Schalters der Schalteinrichtung 40 kann die Stromquelle 36 entkoppelt werden. Auf diese Weise erfolgt ein Entriegeln.

Ein Entriegeln soll beispielsweise erfolgen, wenn eine Bedienperson einen Notschalter betätigt. Dieser ist vorliegend an dem Druckstangenteil 18a des aktiven Flügels 12 angeordnet gezeigt und symbolisch für eine ganze Notschalteinrichtung mit 26 bezeichnet. Notschalter können auch an anderen Stellen einer Türe oder an einer Wand neben der Türzarge 20 angeordnet sein. Es kann auch durch einen in der Druckstange integrierten Schalter eine Notschaltfunktion ausgelöst werden.

Die Fig. 1 zeigt zusätzlich einen Datenbus 28, der einzelne Komponenten der Rettungswegtürvorrichtung miteinander koppelt. Der Datenbus kann zu außerhalb der Rettungswegtürvorrichtung befindlichen Einheiten (z. B. einer zentralen Steuereinheit) geführt sein.

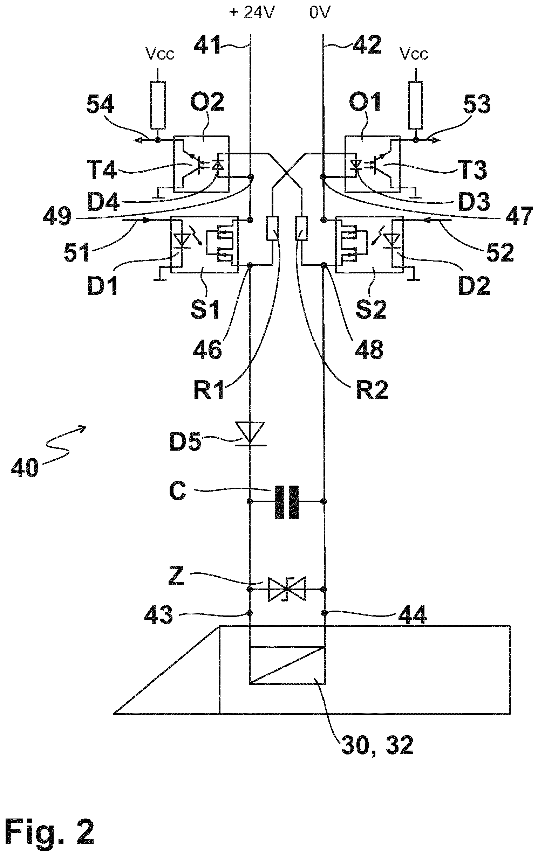

Eine erste Ausführungsform der Schaltereinrichtung 40 ist in Fig. 2 gezeigt. Es geht vorliegend um die Schaltung zwischen zwei Quell-Spannungsabgriffen 41 und 42, an denen die Spannung von der Spannungsquelle 36 abgegriffen werden kann, einerseits und zwei den beiden Elektromagneten 30, 32 (in Fig. 2 symbolisch veranschaulicht) zugeordneten Verbraucher-Abgriffen 43 und 44. Zwischen dem Quell-Spannungsabgriff 41 und dem Verbraucher-Abgriff 43 ist ein erster Schalter S1 in Form eines Foto-MOSFETs dargestellt. Es handelt sich um einen Halbleiterschalter, der über eine Steuerleitung 51 angesteuert wird: Sofern über diese Steuerleitung 51 ein Strom fließt, gemäß einer logischen "1", wird eine Leuchtdiode D1 zum Leuchten gebracht und schaltet die Verbindung zwischen dem Quell-Spannungsabgriff und dem Verbraucher-Abgriff 43 leitend. Entsprechend gibt es einen Foto-MOSFETs S2, der über eine Steuerleitung 52 angesteuert wird und nach demselben Prinzip arbeitet wie der Schalter S1. Zwischen dem verbraucherseitigen Anschluss 46 des Schalters S1 und einem zwischen dem Quell-Spannungsabgriff 42 und dem Schalter S2 vorgesehenen Abgriff 47 ist ein Opto-Koppler O1 geschaltet, in Reihe mit einem Widerstand R1. Entsprechend ist zwischen einem verbraucherseitigen Spannungsabgriff 48 des zweiten Schalters S2 und einem spannungsquellseitigen Abgriff 49 zwischen dem Schalter S1 und der Spannungsquelle ein zweiter Opto-Koppler 02 geschaltet, ebenfalls in Reihe mit einem Widerstand R2. Geschaltet sind jeweils Leuchtdioden D3, D4. Es fließt ein Strom über diese Leuchtdioden D3 und D4. Galvanisch von diesen entkoppelt sind Ausgangsleitungen 53, 54, an denen eine Ausgangsspannung ausgegeben wird.

Unabhängig vom Schaltzustand des Schalters S2 gilt Folgendes: Sofern der Schalter S1 im Grundzustand geschlossen ist, also ein Signal "1" über die Steuerleitung 51 gesendet wird, fließt Strom über die Diode D3, die somit den Transistor T3 des Opto-Kopplers O1 leitend schaltet, wodurch ein Spannungssignal 54 in Form einer logischen "0" ausgegeben wird (da über den Transistor T3 ein Kurzschluss zu Masse erfolgt).

Genauso entspricht einem Fließen eines Stromes über die Diode D2 gemäß einer logischen "1" auf der Steuerleitung 52 ein Aktivieren der Leuchtdiode D4 des Opto-Kopplers 02, ein durchschaltender Transistor T4 und somit das Setzen einer logischen "0" auf der Ausgangsleitung 54.

Die Schaltung 40 umfasst auch eine Diode D5, die verhindert, dass ein Strom bei Entriegelung der beiden Elektromagneten 30, 32 zum Halbleiterschalter fließt. Ferner ist ein nichtpolarisierter Kondensator C vorgesehen, der als Puffer beim Abschalten der Halbleiterschalter wirkt. Ferner ist eine Zenerdiode Z vorgesehen, die den Einfluss der Induktionsspannung der Elektromagneten aufgrund von deren Gegeninduktivität auf die Spannungsquelle unterbindet.

Ein Prüfschema zur Überprüfung der Halbleiterschalter S1 und S2 kann wie folgt und anhand der Tabelle 1 erläutert aussehen:

**Tabelle 1**

| **Schritt** | S1/51 | S2/52 | O1/53 | O2/54 | **Zeit** |
|---|---|---|---|---|---|
| 1 | 0 | 0 | 1 | 1 | 1ms |
| 2 | 1 | 0 | 0 | 1 | 1ms |
| 3 | 0 | 0 | 1 | 1 | 1ms |
| 4 | 0 | 1 | 1 | 0 | 1ms |
| 5 | 1 | 1 | 0 | 0 | 2sek |
| 6 | 0 | 1 | 1 | 0 | 1ms |
| 7 | 1 | 1 | 0 | 0 | X-s |
| 8 | 1 | 0 | 0 | 1 | 1ms |
| 9 | 1 | 1 | 0 | 0 | Y-s |
| 10 | Weiter mit Schritt 6 | | | | |

In einem ersten Schritt wird ein Signal einer logischen "0" auf beide Steuerleitungen 51 und 52 gegeben. Dies entspricht dem Unterbrechen des Fließens von Strom über diese beiden Steuerleitungen. Sofern beide Schalter S1, S2 (und auch die Opto-Koppler O1, 02) korrekt funktionieren, ergibt sich sodann bei den Opto-Kopplern O1 und O2 das Ausgangssignal einer logischen "1". Der Schritt 1 wird für die Dauer einer Millisekunde durchgeführt. Diese Zeit ist derart kurz, dass die beiden Elektromagneten 30, 32 das jeweils zugehörige Feststellelement 38, 39 in seiner Lage nicht verändern: Die durch die Gegeninduktivität der beiden Elektromagneten 30, 32 bestimmte Relaxationszeit ist viel größer als die Zeit von 1 ms. Zudem puffert der Kondensator C das Öffnen der beiden Schalter S1 und S2.

In einem zweiten Schritt wird der Schalter S1 wieder geschlossen, indem über die Steuerleitung 51 eine logische "1" als Signal gesendet wird (also Strom fließt), der Schalter S2 hingegen bleibt geschlossen (logisch "0"). Funktionieren alle Komponenten, so antwortet der Opto-Koppler über die Ausgangsleitung 53 mit einer "0", der Opto-Koppler 02 über die Ausgangsleitung 54 mit einer "1".

Der Schritt 2 wird ebenfalls für eine Zeitdauer von 1 ms durchgeführt.

In einem dritten Schritt werden beide Schalter S1, S2 nochmals geöffnet, jeweils für 1 ms, und in einem vierten Schritt wird dann diesmal der Schalter S2 geschlossen, der Schalter S1 bleibt geöffnet. Während des Einschaltvorgangs, in dem die Schritte 1 bis 4 durchlaufen werden, verstreicht eine Zeit von 4 ms, die insgesamt klein genug ist, um eine Änderung im Zustand der Feststellelemente 38, 39 zu verhindern.

Ab dem Schritt 5 beginnt nun der Normalbetrieb: Im Schritt 5 werden beide Schalter geschlossen, und über die Opto-Koppler O1 und O2 und deren Ausgangsleitungen 53 und 54 wird erfasst, ob die Schalter S1, S2 tatsächlich geschlossen sind. Nach Ablauf von 2 sek wird zum Schritt 6 übergegangen, der Einschaltvorgang wird damit abgeschlossen, und es wird zu einem Dauerbetrieb übergegangen, in dem nachfolgend die Schritte 6-9 wechselnd durchlaufen werden. Im Schritt 6 wird der Schalter S1 geöffnet, und sein ordnungsgemäßes Funktionieren wird anhand einer logischen "1" an der Ausgangsleitung 53 erfasst. Das Öffnen erfolgt auch hier für die Zeitdauer 1 ms.

Im siebten Schritt werden beide Schalter wieder eingeschaltet, und dieser Schritt bleibt für eine Vielzahl von Sekunden bestehen. Es kann sich hierbei um nur wenige Sekunden handeln, es können aber auch mehr als 10 sek sein, z. B. kann der durch Schritt 7 erzeugte Zustand für die Dauer von mehreren Minuten oder gar Stunden aufrecht erhalten bleiben.

In Schritt 8 wird sodann der erste Schalter S1 weiter geschlossen gehalten, wohingegen der Schalter S2 nunmehr geöffnet wird, was anhand einer logischen "1" an der Ausgangsleitung 54 erfasst wird. Das Öffnen des Schalters S2 erfolgt nur für 1 ms, sodass sich am Zustand der Feststellelemente 38 und 39 nichts ändert.

Im Schritt 9 wird derselbe Zustand hergestellt wie in Schritt 7, es werden nämlich beide Schalter geschlossen bzw. geschlossen gehalten. Dieser Zustand bleibt für eine Vielzahl von Sekunden aufrecht erhalten. Die Gesamtheit aus den Sekunden, in denen der Zustand gemäß Schritt 7 aufrecht gehalten wird und den Sekunden, in denen der Zustand 9 aufrecht erhalten wird, bestimmt (bei verschwindendem Beitrag der Schritte 6 und 8) die Dauer eines Prüfzyklusses. Die Prüfung der beiden Schalter S1 und S2 auf Funktionsfähigkeit kann zu beliebigen Zyklen durchgeführt werden, beispielsweise insgesamt einmal pro Minute, einmal pro Viertelstunde oder einmal pro Stunde. Je nach Sicherheitsrelevanz ist sogar eine Prüfung nur einmal pro Tag notwendig.

Nach Durchführung des Schrittes 9 wird zum Schritt 6 zurückgekehrt.

Eine Schleife mit den Schritten 6 bis 9 und dann wieder 6 wird bis zum Abschalten der gesamten Vorrichtung immer wieder durchlaufen.

Im Ausführungsbeispiel der Schalteinrichtung 40 aus Figur 2 sind die beiden Schalter S1 und S2 in parallelen Leitungen geschaltet.

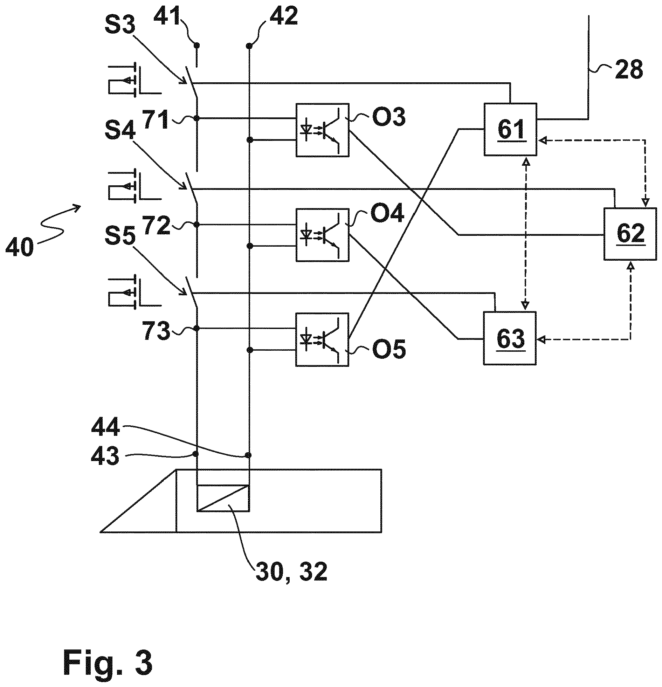

Genauso ist auch eine Schaltung in Reihe möglich. Dies wird nachfolgend anhand von Fig. 3 erläutert:
Ein Schalter S3, der beispielsweise als IGBT ausgebildet ist, ist in Reihe mit Schaltern S4 und S5 zwischen einem Quell-Spannungsabgriff 41 und einem Verbraucher-Abgriff 43 geschaltet. Der Quell-Spannungsabgriff 42 ist unmittelbar mit dem Verbraucher-Spannungsabgriff 44 verbunden. Zwischen einem Abgriff 71 zwischen den Schaltern S3 und S4 und dem Spannungsabgriff 42 ist ein Opto-Koppler 03 geschaltet. Zwischen einem Abgriff 72, der sich zwischen dem Schalter S4 und dem Schalter S5 befindet, und dem Quell-Spannungsabgriff 42 ist ein Opto-Koppler 04 geschaltet. Zwischen dem Schalter S5 und dem Verbraucher-Abgriff 43 befindet sich ein Abgriff 73, an dem ein Opto-Koppler 05 angeschlossen ist, der auch an dem Quell-Spannungsabgriff 42 angeschlossen ist. Ein Mikroprozessor hat vorliegend drei Kerne (sogenannte "cores") 61, 62 und 63. Alternativ kann jeder der Kerne 61, 62, 63 durch einen gesonderten Mikroprozessor bereitgestellt sein. Der Kern 61 steuert den Schalter S3 an und empfängt die Ausgangssignale vom Opto-Koppler 05. Der Kern 62 steuert den Schalter S4 an und empfängt
Ausgangssignale vom Opto-Koppler 03. Der Kern 63 steuert den Schalter S5 an und empfängt Ausgangssignale vom Opto-Koppler 04.

Die nachfolgende Tabelle 2 erläutert eine Prüfreihenfolge:

**Tabelle 2**

| **Schritt** | S3 | S4 | S5 | O3 | O4 | O5 |
|---|---|---|---|---|---|---|
| 1 | 0 | 0 | 0 | 0 | 0 | 0 |
| 2 | 1 | 0 | 0 | 1 | 0 | 0 |
| 3 | 1 | 1 | 0 | 1 | 1 | 0 |
| 4 | 1 | 1 | 1 | 1 | 1 | 1 |
| 5 | 50kHz oder Daten | 1 | 1 | 50kHz oder Daten | 50kHz oder Daten | 50kHz oder Daten |
| 6 | 1 | 100kHz oder Daten | 1 | 1 | 100kHz oder Daten | 100kHz oder Daten |
| 7 | 1 | 1 | 150kHz oder Daten | 1 | 1 | 150kHz oder Daten |

Auch hier wird wieder eine Prüfreihenfolge durchgeführt, mit anfänglichen Schritten 1 - 4 und sodann immer wieder (nämlich zyklisch) wiederholten Schritten 5 - 7. Im Schritt 1 wird überwacht, ob alle Schalter S3, S4, S5 offen sind. Einer logischen "0" bei den Schaltern S3, S4, S5 entspricht eine gleiche "0" bei den Opto-Kopplern O3, O4, O5.

Nun wird der Schalter S3 geschlossen, und es ändert sich im Bereich der Opto-Koppler die Reaktion beim Opto-Koppler O3, dort gibt es eine logische "1". Nachfolgend wird auch zusätzlich noch der Schalter S4 geschlossen, sodass auch der Opto-Koppler O4 eine logische "1" ausgibt. Sodann wird auch noch der Schalter S5 geschlossen, und alle drei Opto-Koppler O3, O4, O5 geben eine logische "1" aus.

Im zyklischen Verfahren wird der Schalter S3 in einem Schritt 5 mit einer Rechteckspannung von 50kHz beaufschlagt. (Die angegebene Frequenz von 50kHz ist lediglich beispielhaft.) Alternativ kann er mit einer Pulsfolge beaufschlagt werden, welche einen Code darstellt, sodass Daten übermittelt werden. Diese Daten können dann im Bereich des Opto-Kopplers O3 (also vom Kern 62) empfangen werden. Gleichermaßen können sie aber auch von den Kernen 63 und 61 empfangen werden. Die Beaufschlagung mit einem Rechteckspuls von 50kHz oder mit entsprechend schneller Pulsung übermittelten Daten hat keine Folge, was den Zustand der Feststellelemente 38, 39 angeht. Die Überprüfung des Schalters S3 erfolgt somit in Schritt 5 im laufenden Betrieb, wobei nach dem Ruhestromprinzip beide Elektromagneten 30, 32 bestromt sind und die Verriegelungseinrichtungen 22 und 24 die Türflügel 12, 14 verriegeln.

Im Schritt 6 bleiben nun die Schalter S3 und S5 geschlossen, nunmehr wird aber der Schalter S4 von dem Kern 62 mit einem Rechteckpuls mit einer Frequenz von 100kHz (oder mit einer Pulsfolge, über die ein Datencode übermittelt wird) beaufschlagt. Diese Signale können nicht vom Opto-Koppler O3 empfangen werden, sondern lediglich von den Opto-Kopplern O4 und O5, also von den Kernen 63 und 61.

Im Schritt 7 werden die Schalter S3 und S4 konstant geschlossen, der Schalter S5 wird aber mit einem Rechteckpuls von 150 kHz oder einer Pulsfolge, welche einen Datencode wiedergibt, beaufschlagt. Auch hier kann lediglich der Opto-Koppler O5 eine Reaktion ermitteln. Bei Beaufschlagung mit 150 kHz empfängt auch der Opto-Koppler O5 die entsprechenden Signale.

Die einzelnen Kerne 61, 62, 63 kontrollieren sich gegenseitig auf ihre Funktionsfähigkeit (siehe die gestrichelten Doppelpfeile). Sie sind in der Lage, z. B. aufgrund einer FFT (schnellen Fourrier-Analyse), die genannten Frequenzen von 50 kHz, 100 kHz und 150 kHz aufzulösen und entsprechend das Vorhandensein der Signale zu erfassen.

Bei Beaufschlagung mit 50 kHz oder mehr (oder zwischen 25kHz und 50kHz) entstehen keine für den Menschen hörbaren Geräusche, sodass die Prüfung der einzelnen Schalter S3, S4, S5 auf Funktionsfähigkeit im laufenden Betrieb ständig wiederholt möglich ist. Die in Tabelle 2 gezeigten Schritte 1 bis 4 werden insgesamt in einer Zeit von nicht mehr als 5 ms durchlaufen. Die Schritte 5 bis 7 können in einer beliebig langen Zeit durchlaufen werden, und die Dauer der Aufrechterhaltung der in den einzelnen Schritten eingestellten Zustände muss für die Schritte 5 bis 7 auch nicht gleich sein.

## Patentansprüche

1. Zugangbestimmende Vorrichtung in einem Gebäude mit zumindest einer Türe (10) und einem der Türe zugeordneten Elektromagneten (30, 32), welcher über zumindest einen Schalter (S1, S2, S3, S4, S5) mit einer Spannungsquelle (36) gekoppelt ist, wobei der Schalter (S1, S2, S3, S4, S5) in einem Grundzustand der zugangbestimmenden Vorrichtung geschlossen ist, sodass der Elektromagnet bestromt ist und dieser bewirkt, dass ein mit einem so erzeugten Magnetfeld (30, 32) des Elektromagneten beaufschlagtes, ebenfalls der Türe zugeordnetes Feststellelement (38, 39) ein Öffnen der Türe (10) oder ein Schließen der Türe verhindert, wobei erst in einem Ausnahmezustand durch dauerhaftes Öffnen des zumindest einen Schalters (S1, S2, S3, S4, S5) ein Wegfall des Magnetfeldes des Elektromagneten (30, 32) bewirkt wird und ein Öffnen der Türe oder ein Schließen der Türe (10) ermöglicht wird,
wobei der zumindest eine Schalter ein Halbleiterschalter (S1, S2, S3, S4, S5) oder sonstiger in einem Millisekundentakt schaltbarer Schalter ist, wobei der Schalter über eine Steuerleitung (51, 52) angesteuert wird, und dass eine Prüfeinrichtung (60, 61, 62, 63) vorgesehen ist, welche ausgelegt ist, zumindest ein Signal zum Bewirken des Öffnens des Schalters (S1, S2, S3, S4, S5) ausgehend von dem Grundzustand für eine derart kurze Zeitdauer über die Steuerleitung (51, 52) auszusenden, dass ein Öffnen, bzw. Schließen der Türe (10) noch nicht ermöglicht wird,
**dadurch gekennzeichnet,**
**dass** die Prüfeinrichtung ferner ausgelegt ist, anhand einer Erfassungseinrichtung (O1, O2, O3, O4, O5) zu prüfen, ob der Schalter (S1, S2, S3, S4, S5) aufgrund des zumindest einen Signals zum Öffnen tatsächlich geöffnet wird und der Elektromagnet über zumindest zwei Halbleiterschalter (S1, S2, S3, S4, S5) (oder zwei sonstige in einem Millisekundentakt schaltbare Schalter) mit zugehöriger Steuerleitung (51, 52) mit der Spannungsquelle redundant derart gekoppelt ist, dass wenn einer der Halbleiterschalter geöffnet wird, der Elektromagnet entregt und der Ausnahmezustand eingenommen wird.

2. Zugangbestimmende Vorrichtung nach Anspruch 1,
**dadurch gekennzeichnet,**
**dass** der Elektromagnet über zumindest zwei Halbleiterschalter (S1, S2; S3, S4, S5) mit zugehöriger Steuerleitung (51, 52) mit der Spannungsquelle (36) gekoppelt ist, wobei die Prüfeinrichtung (60, 61, 62, 63) ausgelegt ist, die zumindest zwei Halbleiterschalter (S1, S2; S3, S4, S5) in wechselnder Konfiguration anzusteuern.

3. Zugangbestimmende Vorrichtung nach Anspruch 2,
**dadurch gekennzeichnet,**
**dass** die Spannungsquelle (36) zwei Quell-Spannungsabgriffe (41, 42) hat, die im Grundzustand jeweils mit einem Verbraucher-Spannungsabgriff (43, 44) des Elektromagneten (30, 32) gekoppelt sind, wobei
a) jeweils zwischen einem Quell-Spannungsabgriff (41, 42) und einem Verbraucher-Spannungsabgriff (43, 44) zumindest ein Halbleiterschalter (S1, S2) angeordnet ist, und/oder
b) zwischen einem der Quell-Spannungsabgriffe (41) und einem der Verbraucher-Spannungsabgriffe (43) zumindest zwei Halbleiterschalter (S3, S4, S5) in Reihe geschaltet angeordnet sind.

4. Zugangbestimmende Vorrichtung nach Anspruch 3,
**gekennzeichnet durch** zumindest ein kapazitives Element (6) und/oder eine bipolare Diode (Z) und/oder einen Varistor, welches, bzw. welche, bzw. welcher die beiden Verbraucher-Spannungsabgriffe (43, 44) koppelt.

5. Zugangbestimmende Vorrichtung nach einem der vorhergehenden Ansprüche,
**dadurch gekennzeichnet,**
**dass** die Erfassungseinrichtung zu jedem Halbleiterschalter ein Halbleiterbauelement (O1, O2, O3, O4, O5) umfasst, welches über eine Ausgangsleitung (53, 54) zumindest ein Spannungssignal ausgibt.

6. Zugangbestimmende Vorrichtung nach Anspruch 5, in dessen Rückbezug auf einen der Ansprüche 2 - 4,
**dadurch gekennzeichnet,**
**dass** eine Steuereinrichtung, insbesondere ein Mikroprozessor (60, 61, 62, 63) oder ein Mikrocontroller, ausgelegt ist, Signale über die Steuerleitungen an die Halbleiterschalter (S1, S2, S3, S4, S5) zur Ansteuerung in wechselnder Konfiguration auszusenden und entsprechende Spannungssignale von den Halbleiterbauelementen (O1, O2, O3, O4, O5) der Erfassungseinrichtung zu empfangen.

7. Zugangbestimmende Vorrichtung nach Anspruch 6,
**dadurch gekennzeichnet,**
**dass** die Steuereinrichtung ausgelegt ist, die Halbleiterschalter (S3, S4, S5) mit unterschiedlichen Signalfolgen zu beaufschlagen, die sich vorzugsweise durch ihre Frequenz voneinander unterscheiden.

8. Zugangbestimmende Vorrichtung nach einem der vorhergehenden Ansprüche,
**dadurch gekennzeichnet,**
**dass** eine Steuerleitung (51, 52) für jeden Halbleiterschalter galvanisch von den Elektromagneten (30, 32) und/oder der Spannungsquelle (36) entkoppelt ist.

9. Zugangbestimmende Vorrichtung nach Anspruch 8 in dessen Rückbezug auf einen der Ansprüche 5-7,
**dadurch gekennzeichnet,**
**dass** auch die Ausgangsleitungen der Halbleiterbauelemente (O1, O2, O3, O4, O5) galvanisch von den Elektromagneten (30, 32) und/oder der Spannungsquelle entkoppelt sind.

10. Zugangbestimmende Vorrichtung nach einem der vorhergehenden Ansprüche,
**dadurch gekennzeichnet,**
**dass** die Prüfeinrichtung ausgelegt ist, den oder die Schalter gemäß einem Code anzusteuern, um eine Information zu übermitteln, und/oder dass die Prüfeinrichtung einen Zufallsgenerator umfasst, um insbesondere den Zeitpunkt des Aussendens eines Signals zum Bewirken des Öffnens des Schalters festzulegen, und/oder ein pulsweitenmoduliertes Signal abgibt, insbesondere um eine Verriegelungseinrichtung anzusteuern.

11. Zugangbestimmende Vorrichtung nach einem der vorhergehenden Ansprüche,
**dadurch gekennzeichnet,**
**dass** die kurze Zeitdauer, über die der zumindest eine Halbleiterschalter oder sonstige Schalter geöffnet wird, weniger als 6 ms währt, vorzugsweise zwischen 0,5 und 2 ms währt.

12. Zugangbestimmende Vorrichtung nach einem der Ansprüche 1 -11,
**dadurch gekennzeichnet,**
**dass** die Türe eine Rettungswegtüre (10) ist und das Feststellelement (38, 39) dazu dient, einen Türflügel an einer Türzarge der Rettungswegtüre (10) zu halten oder Teil eines elektrischen Türöffners an der Rettungswegtüre ist oder eine Druckstange (18a, 18b) an der Rettungswegtüre verriegelt.

13. Zugangbestimmende Vorrichtung nach einem der Ansprüche 1-11,
**dadurch gekennzeichnet,**
**dass** die Türe eine Brandschutztüre ist und das Feststellelement dazu dient, die Türe in einem geöffneten Zustand zu halten.

14. Verfahren zum Prüfen eines Halbleiterschalters in einer
zugangbestimmenden Vorrichtung eines Gebäudes nach einem der vorangehenden Ansprüche mit zumindest einer Türe (10), der ein Elektromagnet (30, 32) zugeordnet ist, welcher über den zu prüfenden Halbleiterschalter (S1, S2, S3, S4, S5) mit einer Spannungsquelle (36) gekoppelt ist, wobei der Halbleiterschalter (S1, S2, S3, S4, S5) in einem Grundzustand der zugangbestimmenden Vorrichtung geschlossen ist, sodass der Elektromagnet bestromt ist und bewirkt, dass ein mit einem so erzeugten Magnetfeld des Elektromagneten (30, 32) beaufschlagtes, ebenfalls der Türe zugeordnetes Feststellelement (38, 39) ein ordnungsgemäßes Öffnen der Türe oder ein ordnungsgemäßes Schließen der Türe verhindert, wobei erst in einem Ausnahmezustand durch dauerhaftes Öffnen des zumindest einen Schalters (S1, S2, S3, S4, S5) ein Wegfall des Magnetfeldes des Elektromagneten (30, 32) bewirkt wird und ein Öffnen der Türe (10) oder ein Schließen der Türe ermöglicht wird, wobei der Halbleiterschalter (S1, 52, 53, 54, 55) für eine derart kurze Zeitdauer geöffnet wird, insbesondere für weniger als 6 ms so dass ein Öffnen bzw. Schließen der Türe (10) noch nicht ermöglicht wird,
**dadurch gekennzeichnet,**
**dass** der Elektromagnet über zumindest zwei Halbleiterschalter (S1, S2, S3, S4, S5) mit zugehöriger Steuerleitung (51, 52) mit der Spannungsquelle redundant derart gekoppelt ist, dass wenn einer der Halbleiterschalter geöffnet wird, der Elektromagnet entregt und der Ausnahmezustand eingenommen wird, und das Öffnen eines Halbleiterschalters (S1, S2, S3, S4, S5) mittels einer Erfassungseinrichtung (O1, O2, O3, O4, O5) detektiert wird.

15. Verfahren nach Anspruch 14,
**dadurch gekennzeichnet,**
**dass** das Öffnen des Halbleiterschalters (S1, S2, S3, S4, S5) in einem Grundbetrieb zumindest täglich, bevorzugt mindestens stündlich, ganz bevorzugt mehrmals stündlich wiederholt wird.

## Claims

1. Access-determining device in a building having at least one door (10) and one electromagnet (30, 32) assigned to the door, said electromagnet being coupled to a voltage source (36) via at least one switch (S1, S2, S3, S4, S5), wherein the switch (S1, S2, S3, S4, S5) is closed in a base state of the access-determining device, such that the electromagnet is powered and this electromagnet causes a fixing element (38, 39), which is supplied by a magnetic field (30, 32) of the electromagnet, said magnetic field being thus generated, and which is likewise assigned to the door, to prevent the door (10) from opening or closing, wherein a lapse of the magnetic field of the electromagnet (30, 32) is caused only in an emergency state by permanent opening of the at least one switch (S1, S2, S3, S4, S5), and an opening of the door or a closing of the door (10) is enabled,
wherein the at least one switch is a semiconductor switch (S1, S2, S3, S4, S5) or another switch which can be switched every millisecond, wherein the switch is controlled via a control line (51, 52), and a testing means (60, 61, 62, 63) is provided which is designed to emit at least one signal for causing the opening of the switch (S1, S2, S3, S4, S5) via the control line (51, 52), based on the base state, for a sufficiently short period of time that opening or closing of the door (10) is not yet enabled,
**characterised in that**
the testing means is further designed to test, using a detection means (01, 02, 03, 04, 05), whether the switch (S1, S2, S3, S4, S5) is actually opened because of the at least one signal for opening, and the electromagnet is redundantly coupled to the voltage source via at least two semiconductor switches (S1, S2, S3, S4, S5) (or two other switches which can be switched every millisecond) having an associated control line (51, 52) in such a manner that, when the semiconductor switch is opened, the electromagnet is deenergised and the emergency state is established.

2. Access-determining device according to claim 1,
**characterised in that**
the electromagnet is coupled to the voltage source (36) via at least two semiconductor switches (S1, S2; S3, S4, S5) having a corresponding control line (51, 52), wherein the testing means (60, 61, 62, 63) is designed to control the at least two semiconductor switches (S1, S2; S3, S4, S5) in an alternating configuration.

3. Access-determining device according to claim 2,
**characterised in that**
the voltage source (36) has two source voltage taps (41, 42) which are respectively coupled to a user voltage tap (43, 44) of the electromagnet (30, 32) in the base state, wherein
a) at least one semiconductor switch (S1, S2) is respectively arranged between a source voltage tap (41, 42) and a user voltage tap (43, 44), and/or
b) at least two semiconductor switches (S3, S4, S5) are arranged connected in series between one of the source voltage taps (41) and one of the user voltage taps (43).

4. Access-determining device according to claim 3,
**characterised by** at least one capacitive element (6) and/or a bipolar diode (Z) and/or a varistor which couples the two user voltage taps (43, 44).

5. Access-determining device according to one of the preceding claims,
**characterised in that**
the detection means comprises a semiconductor component (O1, O2, O3, O4, O5) for each semiconductor switch, said semiconductor component outputting at least one voltage signal via an output line (53, 54).

6. Access-determining device according to claim 5, as appendant to one of claims 2 - 4,
**characterised in that**
a control means, in particular a microprocessor (60, 61, 62, 63) or a microcontroller, is designed to emit signals via the control lines to the semiconductor switches (S1, S2, S3, S4, S5) for controlling in alternating configuration and to receive corresponding voltage signals from the semiconductor components (O1, O2, O3, O4, O5) of the detection means.

7. Access-determining device according to claim 6,
**characterised in that**
the control means is designed to supply the semiconductor switches (S3, S4, S5) with different signal sequences which preferably differ from one another in their frequency.

8. Access-determining device according to one of the preceding claims,
**characterised in that**,
for each semiconductor switch, a control line (51, 52) is galvanically decoupled from the electromagnets (30, 32) and/or the voltage source (36).

9. Access-determining device according to claim 8, as appendant to one of claims 5-7,
**characterised in that**
the output lines of the semiconductor components (O1, O2, O3, O4, O5) are also galvanically decoupled from the electromagnets (30, 32) and/or the voltage source.

10. Access-determining device according to one of the preceding claims,
**characterised in that**
the testing means is designed to control the switch or switches according to a code in order to transmit information, and/or the testing means comprises a random generator in order to set, in particular, the point in time of emitting a signal for causing the opening of the switch, and/or delivers a pulse width modulated signal, in particular in order to control a locking means.

11. Access-determining device according to one of the preceding claims,
**characterised in that**
the short time period over which the at least one semiconductor switch or other switches is opened lasts less than 6ms, preferably lasts between 0.5 and 2ms.

12. Access-determining device according to one of claims 1-11,
**characterised in that**
the door is an emergency exit door (10), and the fixing element (38, 39) serves for holding a door leaf on a door frame of the emergency exit door (10) or is part of an electrical door opener on the emergency exit door or locks a push bar (18a, 18b) on the emergency exit door.

13. Access-determining device according to one of claims 1 to 11,
**characterised in that**
the door is a fire safety door, and the fixing element serves for holding the door in an open state.

14. Method for testing a semiconductor switch in an access-determining device of a building according to one of the preceding claims, having at least one door (10) to which an electromagnet (30, 32) is assigned which is coupled to a voltage source (36) via the semiconductor switch (S1, S2, S3, S4, S5) which is to be tested, wherein the semiconductor switch (S1, S2, S3, S4, S5) is closed in a base state of the access-determining device, such that the electromagnet is powered and causes a locking element (38, 39) which is supplied with a magnetic field of the electromagnet (30, 32), said magnetic field being thus generated, and which is likewise assigned to the door, to prevent a proper opening of the door or a proper closing of the door, wherein a lapse of the magnetic field of the electromagnet (30, 32) is caused only in an emergency state by permanent opening of the at least one switch (S1, S2, S3, S4, S5), and an opening of the door (10) or a closing of the door is enabled, wherein the semiconductor switch (S1, 52, 53, 54, 54) is opened for a sufficiently short time period, in particular for less than 6ms, that an opening or closing of the door (10) is not yet enabled,
**characterised in that**
the electromagnet is redundantly coupled to voltage source via at least two semiconductor switches (S1, S2, S3, S4, S5) having the associated control line (51, 52) in such a way that, when one of the semiconductor switches is opened, the electromagnet is deenergised and the emergency state is established, and the opening of a semiconductor switch (S1, S2, S3, S4, S5) is detected by means of a detection means (O1, O2, O3, O4, O5).

15. Method according to claim 14,
**characterised in that**
opening the semiconductor switch (S1, S2, S3, S4, S5) in a basic operation is repeated at least daily, preferably at least hourly, most preferably more than hourly.

## Revendications

1. Dispositif de détermination d'accès dans un bâtiment avec au moins une porte (10) et un électro-aimant (30, 32) correspondant à la porte, qui est couplé, par l'intermédiaire d'au moins un commutateur (S1, S2, S3, S4, S5), avec une source de tension (36), dans lequel le commutateur (S1, S2, S3, S4, S5) est fermé dans un état de base du dispositif de détermination d'accès, de façon à ce que l'électro-aimant soit alimenté et qu'il fasse en sorte qu'un élément d'arrêt (38, 39), sollicité par un champ magnétique (30, 32) généré par l'électro-aimant, correspondant également à la porte, empêche une ouverture de la porte (10) ou une fermeture de la porte, dans lequel une désactivation du champ magnétique de l'électro-aimant (30, 32) n'est provoquée et une ouverture de la porte ou une fermeture de la porte (10) n'est autorisée que dans un état d'exception par une ouverture durable de l'au moins un commutateur (S1, S2, S3, S4, S5), l'au moins un commutateur étant un commutateur semi-conducteur (S1, S2, S3, S4, S5) ou un autre commutateur pouvant être commuté avec une cadence de l'ordre d'une milliseconde, le commutateur étant contrôlé par l'intermédiaire d'une conduite de commande (51, 52) et en ce qu'un dispositif de vérification (60, 61, 62, 63) est prévu, qui est conçu pour émettre au moins un signal provoquant l'ouverture du commutateur (S1, S2, S3, S4, S5) à partir de l'état de base pour une durée courte par l'intermédiaire de la conduite de commande (51, 52), de façon à ce qu'une ouverture ou une fermeture des portes (10) ne soit pas encore autorisée,
**caractérisé en ce que**
le dispositif de vérification est en outre conçu pour vérifier, à l'aide d'un dispositif de détection (O1, O2, O3, O4, O5), si le commutateur (S1, S2, S3, S4, S5) est effectivement ouvert du fait de l'au moins un signal d'ouverture et l'électro-aimant est couplé, de manière redondante, par l'intermédiaire d'au moins deux commutateurs semi-conducteurs (S1, S2, S3, S4, S5) (ou de deux commutateurs pouvant être commutés avec une cadence de l'ordre d'une milliseconde), avec la conduite de commande (51, 52) avec la source de tension de façon à ce que, lorsqu'un des commutateurs semi-conducteurs est ouvert, l'électro-aimant est désexcité et l'état d'exception est activé.

2. Dispositif de détermination d'accès selon la revendication 1,
**caractérisé en ce que**
l'électro-aimant est couplé, par l'intermédiaire d'au moins deux commutateurs semi-conducteurs (S1, S2, S3, S4, S5), avec une conduite de commande (51, 52) correspondante avec la source de tension (36), le dispositif de vérification (60, 61, 62, 63) étant conçu pour contrôler les au moins deux commutateurs semi-conducteurs (S1, S2, S3, S4, S5) avec une configuration variable.

3. Dispositif de détermination d'accès selon la revendication 2,
**caractérisé en ce que**
la source de tension (36) comprend deux prises de tension source (41, 42) qui sont couplées, dans l'état de base, chacune avec une prise de tension consommatrice (43, 44) de l'électro-aimant (30, 32), dans lequel
a) entre une prise de tension source (41, 42) et une prise de tension consommatrice (43, 44) est disposé dans chaque fois au moins un commutateur semi-conducteur (S1, S2) et/ou
b) entre une des prises de tension source (41) et une des prises de tension consommatrices (43) sont disposés branchés en série au moins deux commutateurs semi-conducteurs (S3, S4, S5).

4. Dispositif de détermination d'accès selon la revendication 3,
**caractérisé par** au moins un élément capacitif (6) et/ou une diode bipolaire (Z) et/ou un variateur, qui couple les deux prises de tension consommatrices (43, 44).

5. Dispositif de détermination d'accès selon l'une des revendications précédentes,
**caractérisé en ce que**
le dispositif de détection comprend, correspondant à chaque commutateur semi-conducteur, un composant semi-conducteur (O1, O2, O3, O4, O5) qui émet au moins un signal de tension par l'intermédiaire d'une conduite de sortie (53, 54).

6. Dispositif de détermination d'accès selon la revendication 5,
**caractérisé en ce que**
un dispositif de commande, plus particulièrement un micro-processeur (60, 61, 62, 63) ou un micro-contrôleur, est conçu pour envoyer des signaux par l'intermédiaire des conduites de commande aux commutateurs semi-conducteurs (S1, S2, S3, S4, S5) pour un contrôle à configuration variable et pour recevoir des signaux de tension correspondants en provenance des composants semi-conducteurs (O1, O2, O3, O4, O5) du dispositif de détection.

7. Dispositif de détermination d'accès selon la revendication 6,
**caractérisé en ce que**
le dispositif de commande est conçu pour alimenter les commutateurs semi-conducteurs (S1, S2, S3, S4, S5) avec différentes séries de signaux qui se distinguent entre eux de préférence par leur fréquence.

8. Dispositif de détermination d'accès selon l'une des revendications précédentes,
**caractérisé en ce que**
une conduite de commande (51, 52) pour chaque commutateur semi-conducteur est découplée galvaniquement des électro-aimants (30, 32) et/ou de la source de tension (36).

9. Dispositif de détermination d'accès selon la revendication 8 en référence à une des revendications 5 à 7,
**caractérisé en ce que**
les conduites de sortie des composants semi-conducteurs (O1, 02, 03, 04, 05) sont également découplées galvaniquement des électro-aimants (30, 32) et/ou de la source de tension.

10. Dispositif de détermination d'accès selon l'une des revendications précédentes,
**caractérisé en ce que**
le dispositif de vérification est conçu pour contrôler le ou les commutateurs selon un code afin de transmettre une information et/ou **en ce que** le dispositif de vérification comprend un générateur aléatoire afin de déterminer plus particulièrement le moment de l'envoi d'un signal provoquant l'ouverture du commutateur et/ou émet un signal modulé en largeur d'impulsion, plus particulièrement afin de contrôler un dispositif de verrouillage.

11. Dispositif de détermination d'accès selon l'une des revendications précédentes,
**caractérisé en ce que**
la courte durée pendant laquelle l'au moins un commutateur semi-conducteur ou d'autres commutateurs sont ouverts, est inférieure à 6 ms, de préférence entre 0,5 et 2 ms.

12. Dispositif de détermination d'accès selon l'une des revendications 1 à 11,
**caractérisé en ce que**
la porte est une porte d'issue de secours (10) et l'élément d'arrêt (38, 39) permet de maintenir un battant de porte sur un chambranle de la porte d'issue de secours (10) ou fait partie d'une gâche électrique sur la porte d'issue de secours ou verrouille une barre de poussée (18a, 18b) sur la porte d'issue de secours.

13. Dispositif de détermination d'accès selon l'une des revendications 1 à 11,
**caractérisé en ce que**
la porte est une porte anti-incendie et l'élément d'arrêt permet de maintenir la porte dans un état ouvert.

14. Procédé de vérification d'un commutateur semi-conducteur dans un dispositif de détermination d'accès d'un bâtiment selon l'une des revendications précédentes, avec au moins une porte (10), à laquelle correspond un électro-aimant (30, 32), qui est couplé, par l'intermédiaire du commutateur semi-conducteur (S1, S2, S3, S4, S5) à vérifier, avec une source de tension (36), le commutateur semi-conducteur (S1, S2, S3, S4, S5) étant fermé dans un état de base du dispositif de détermination d'accès, de façon à ce que l'électro-aimant soit alimenté et fasse en sorte qu'un élément d'arrêt (38, 39), alimenté avec un champ magnétique généré par l'électro-aimant (30, 32), correspondant également à la porte, empêche une ouverture correcte de la porte ou une fermeture correcte de la porte, moyennant quoi une désactivation du champ magnétique de l'électro-aimant (30, 32) n'étant provoquée et une ouverture de la porte (10) ou une fermeture de la porte n'étant autorisée que dans un état d'exception par une ouverture durable de l'au moins un commutateur (S1, S2, S3, S4, S5), le commutateur semi-conducteur (S1, S2, S3, S4, S5) étant ouvert pendant une courte durée, plus particulièrement pendant moins de 6 ms, de façon à ce qu'une ouverture ou une fermeture de la porte (10) ne soit pas encore autorisée,
**caractérisé en ce que**
l'électro-aimant est couplé de manière redondante, par l'intermédiaire d'au moins deux commutateurs semi-conducteurs (S1, S2, S3, S4, S5), avec une conduite de commande (51, 52) correspondante, de façon à ce que, lorsqu'un des commutateurs semi-conducteurs est ouvert, l'électro-aimant est désexcité et l'état d'exception est activé, et l'ouverture d'un commutateur semi-conducteur (S1, S2, S3, S4, S5) est détectée au moyen d'un dispositif de détection (O1, O2, O3, O4, 05).

15. Procédé selon la revendication 14,
**caractérisé en ce que**
l'ouverture du commutateur semi-conducteur (S1, S2, S3, S4, S5) répétée, dans un fonctionnement de base, au moins quotidiennement, de préférence au moins toutes les heures, de préférence plusieurs fois par heure.
